# EUROPEAN PATENT APPLICATION

(11) **EP 0 584 917 A2**
(43) Date of publication of application: **02.03.1994**
(21) Application number: 93305406.6
(22) Date of filing: 09.07.1993
(51) Int. Cl.: G06F 11/26

(54) **System and method for testing a programmable logic**

(30) Priority: 27.08.1992 US 936895
(71) Applicant: ADVANCED MICRO DEVICES, INC., Sunnyvale, CA 94088 (US)
(72) Inventor: Pedneau, Michael D., Austin, Texas 78735 (US)
(74) Representative: BROOKES & MARTIN

(57) **Abstract**

The present invention provides a system and method for self-testing and self-checking programmable logic. According to the preferred embodiment, a system is provided which includes a multiplexer having an output coupled to the input of programmable logic, and inputs coupled to normal input signal sources and a pseudo-random number generator. The multiplexer selectively couples an input to its output responsive to an input source signal. The output of the programmable logic is applied to normal output components and a data compression register which is controlled by a read enable signal. The system further includes a configuration control which independently generates the input select signal and the read enable signal.

## Description

This invention relates to a programmable logic system and method such as apparatus and method for testing the integrity of programmable logic, such as a system and method for self-testing and self-checking programmable logic.

As society's dependency on computer systems and computer-controlled devices grows, it becomes increasingly important to verify the integrity of the components which make up such systems. Programmable logic, such as programmable logic arrays, represents one family of computer components whose functioning is integral to a wide range of computer systems.

One method of testing the integrity of programmable logic consists of transmitting a series of random numbers into the input of the programmable logic, accumulating the outputs generated by the programmable logic in a data compression register (DCR), and, when the entire series of numbers has been processed by the programmable logic, comparing the output signature of the DCR with a predetermined correct signature. If the DCR output signature matches the correct signature, then the programmable logic is functioning properly; otherwise, it is faulty.

Consequently, programmable logic architectures have been developed which provide built-in self-testing (BIST). Such architectures contain, in addition to programmable logic, the hardware required to test the programmable logic (i.e. a pseudo random number generator (PRNG) and a DCR) and a testing mode enable switch for switching from a normal operating mode to a self-testing mode. During normal operation, the programmable logic receives data from normal inputs and transmits data to normal outputs. When self-testing mode is enabled, the programmable logic receives input from the PRNG and transmits its output to the DCR.

One disadvantage of current BIST architectures is that the programmable logic cannot be used for normal operation while in self-testing mode. Conversely, the integrity of the programmable logic cannot be determined during normal operations. Another disadvantage of current BIST architectures is that the scope of the testing provided thereby does not extend beyond the integrity of the programmable logic itself. Thus, an error in another part of the system comprising the programmable logic will not be detected. Yet another disadvantage of current BIST architectures is that the resulting output signature does not provide information that may be helpful in identifying the source of a problem, such as the system status when an error occurs, or which specific programmable logic input caused an error.

It is therefore clearly desirable to provide a system and method for verifying the integrity of programmable logic while the programmable logic continues to operate normally. It is further desirable to provide a system and method for verifying the integrity of the system comprising the programmable logic (self-checking), as well as the integrity the programmable logic itself (self-testing). It is further desirable to provide a system and method for identifying the particular input values and system states which cause integrity errors.

We will describe a programmable logic arrangement disposed in a system having normal signal sources. The arrangement includes programmable logic having a multiple-bit input and a multiple-bit output, wherein the input of the programmable logic is couplable to the normal signal sources. The arrangement further includes a data compression register coupled to the output of the programmable logic, the data compression register having a clock input and a read input. The data compression register compresses data from the output of the programmable logic when the read input is disabled and pulses are applied to the clock input. The data compression register may be enabled when the input of the programmable logic is coupled to either the normal signal sources or to the PRNG.

We will also describe a programmable logic arrangement disposed in a system having normal signal sources and normal processed signal receivers is provided. The arrangement generally includes a pseudo random number generator, and programmable logic having a multiple-bit input and a multiple-bit output. The output of the programmable logic is coupled to the normal processed signal receivers. The arrangement further includes a multiplexer coupled to the pseudo random number generator, the normal input sources, and the input of the programmable logic. The multiplexer has a source selection input, wherein the multiplexer transmits data from the pseudo random number generator to the programmable logic when the source selection input is enabled, and transmits data from the normal signal sources to the programmable logic when the source selection input is disabled.

A data compression register is coupled to the output of the programmable logic. The register has a clock input, a read input, and a signature output. The data compression register receives data from the output of the programmable logic when the read input is disabled and pulses are applied to the clock input, and does not receive input from the output of the programmable logic when either the read input is enabled or pulses are not applied to the clock input. The source selection input of the multiplexer may be enabled independent of the clock and read inputs of the data compression register.

We will also describe a method of testing the integrity of a system including normal signal sources and programmable logic with a multiple-bit input and a multiple-bit output is provided. The testing method includes the steps of applying an input signal generated by the normal signal sources to the input of the programmable logic, and generating an output signal at the output of the programmable logic.

The method includes the further steps of compressing the output signal in a data compression register, and generating a signature output representative of the output signal. The output signature is compared to a predetermined correct signature.

We will also describe a method of testing a system comprising normal input signal sources, a pseudo random number generator, programmable logic having a multiple-bit input and a multiple-bit output, means for selectively coupling the pseudo random number generator and the normal input signal sources to the input of the programmable logic, and a data compression register is provided. The method includes the steps of coupling the normal input sources to the input of the programmable logic and applying an input signal generated by the normal input sources to the input of the programmable logic. An output signal is generated at the output of the programmable logic, and is compressed in the data compression register. An output signature representative of the output signal is generated and compared with a predetermined correct signature.

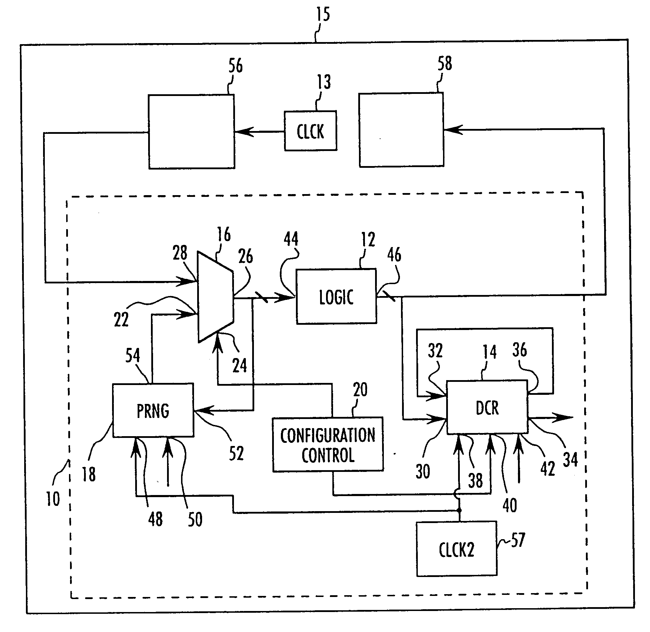

### BRIEF DESCRIPTION OF THE DRAWING

A preferred exemplary embodiment will hereinafter be described in conjunction with the appended drawing, wherein the sole figure of which is a block diagram of a system having programmable logic testing arrangement according to the preferred embodiment of the present invention.

### DETAILED DESCRIPTION OF THE PREFERRED EMBODIMENT

Referring to the Figure, programmable logic arrangement 10 is shown according to the presently preferred embodiment of the invention. Arrangement 10 generally comprises programmable logic 12, a DCR 14, a multiplexer 16, a PRNG 18, and a configuration control 20. Arrangement 10 is disposed in a computer system 15 which comprises, in addition to arrangement 10, normal signal sources 56, and normal processed signal receivers 58.

Normal signal sources 56 and normal processed signal receivers 58 generally represent the electronic components and circuitry of system 15 with which programmable logic 12 interacts in a given application. The nature and logic of these components will vary according to the application implemented. Signal sources 56 change states as they are driven by a system clock 13. For example, system 15 may include a programmed microprocessor driven by system clock 13. At each cycle of clock 13, the microprocessor executes an instruction, and the microprocessor's program counter increments to point at the next instruction to be performed. The execution of the instruction causes the state of the components of system 15, including signal sources 56, to change.

Programmable logic 12 may be a conventional programmable logic array, and generally comprises an input port 44, and an output port 46. Programmable logic 12 is designed to generate an output signal at output port 46 responsive to an input signal applied to input port 44. The relationship between the input and output signals of programmable logic 12 is determined by the specific logic implemented in programmable logic 12, which will vary according to each application. Input port 44 is connected to an output port 26 of multiplexer 16.

Output port 46 of programmable logic 12 is connected to a data input port 30 of DCR 14, and to processed signal receivers 58. Responsive to signals applied at input port 44, programmable logic 12 transmits an output signal at output port 46. The output signal is transmitted to processed signal receivers 58 which operate responsive thereto. As mentioned above, the specific circuitry and components represented by processed signal receivers 58 will vary based on the specific application addressed by system 15.

DCR 14 may be a conventional data compression register. DCR 14 generally comprises data input port 30, a feedback input port 32, a signal out port 34, a feedback out port 36, a clock input 38, a read input 40, and a reset input 42.

The contents of DCR 14 are reset when a logical HIGH is applied at reset input 42. The signal at read input 40 must be LOW to affect data compression in DCR 14. When the clock input 38 is pulsed while read input 40 is LOW, the data supplied at data input port 30 is combined and shifted with the current contents of DCR 14. Through linear shift feedback from feedback out port 36 to input port 32, the result of previous combinations is also combined with the data from input port 30. While a logical HIGH is applied at read input 40, the current contents of DCR 14 are accessed through signal out port 34 by applying clock pulses to clock input 38. At each pulse, one bit of the contents of DCR 14 is made available at signal out port 34. The sequence of bits thus output at signal out port 34 comprises an output signature which may be compared with a predetermined correct signature.

Multiplexer 16 generally comprises a plurality of input ports 28 and 22, a source selection port 24, and output port 26. The signal applied at source selection port 24 determines which input port of multiplexer 16 will be coupled to output port 26. Specifically, when a logical LOW is applied at source selection port 24, input port 28 is coupled to output port 26. Conversely, when a logical HIGH is applied at source selection port 24, input port 22 is coupled to output port 26. Output port 26 is connected to an input port 52 of PRNG 18 and input port 44 of programmable logic 12. Input port 28 is connected to signal sources 56, and input port 22 is connected to an output port 54 of PRNG 18.

PRNG 18 may be a conventional pseudo-random number generator, and generally comprises a clock input 48, a reset input 50, input port 52, and output port 54. The contents of PRNG 18 are reset when a logical HIGH is applied to reset input 50. This provides a "seed" value to PRNG 18. When a pulse is applied to clock input 48, PRNG 18 generates a random number at port 54. PRNG 18 is reseeded with its previous output, which is recycled through input port 52.

As discussed above, prior art BIST programmable logic circuits may operate in either one of two modes, a normal or operating mode, or a testing mode. The operating mode of such circuits is determined by a single BIST enable switch, which controls both the input source to the programmable logic and the compression status of the associated DCR. Hence, when the programmable logic is receiving data from normal input sources, the DCR is always deactivated, and when the programmable logic is receiving data from a PRNG, the DCR read is always activated. In contrast to the prior art, the input source to programmable logic 12 and the read status of DCR 14 are independently selectable through signals applied by configuration control 20 to source selection port 24 and read input 40, respectively. By decoupling the control of multiplexer 16 and DCR 14, the arrangement 10 of the present invention may perform self-checking as well as self-testing, and may provide advanced verification features not available in conventional BIST programmable logic architectures.

No functionality is lost by decoupling the control of multiplexer 16 and DCR 14, since these components may still be controlled to emulate the normal and testing modes provided by prior art BIST circuits. For example, to emulate normal mode, configuration control 20 may apply a logical LOW to source selection port 24 of multiplexer 16 and a logical HIGH to read input 40 of DCR 14. Thus configured, data will flow from signal sources 56 through programmable logic 12 to processed signal receivers 58 without affecting DCR 14. To emulate the testing mode of the prior art, configuration control 20 may apply a logical HIGH to source selection port 24 of multiplexer 16 and a LOW to read input 40 of DCR 14 while pulses applied to the clock input 38. Thus configured, data flows from PRNG 18 through programmable logic 12 and is read into DCR 14 at input port 30 as clock pulses are applied at clock inputs 38 and 48. As a result, arrangement 10 may perform the self-testing function provided in the prior art to verify the internal integrity of programmable logic 12 while system 15 is not in normal operation.

Unlike the prior art, however, the present system further provides self-checking and enhanced debugging features. In accordance with this preferred embodiment, this is accomplished by configuration control 20 independently controlling source selection port 24, clock input 38, and read input 40. For example, configuration control 20 may provide a logical LOW at read input 40 and a logical LOW at source selection port 24 while pulses are applied at clock input 38. In this configuration, data flows from signal sources 56 through programmable logic 12 to processed signal receivers 58 to allow normal system operation. However, unlike the normal mode provided by prior art BIST circuits, DCR 14 reads and compresses the data generated at output port 46 of programmable logic 12. After a predetermined number of clock cycles, configuration control 20 may then apply a logical HIGH at read input 40, and clock input 38 may be pulsed to supply an output signature at signal out port 34. The output signature may be compared with a predetermined correct signature to determine whether an error has occurred. A failure of the output signature to match the predetermined correct signature indicates an error within programmable logic 12, an error within signal sources 56, or both. Thus, both self-testing (verification of programmable logic 12 itself) and self-checking (verification of the other components of system 15) are provided.

According to another aspect of the present invention, enhanced debugging may be performed through single-step checking. Single-step checking allows for verification of system 15 after each cycle of system clock 13. To begin single-step checking, a logical HIGH is applied to reset input 42 to reset DCR 14, then configuration control 20 provides a logical LOW to read input 40. A logical LOW is applied to source selection port 24 by configuration control 20, allowing data to flow from signal sources 56 to programmable logic 12. At the first cycle of system clock 13, the state of sources 56 is altered and data indicative of the new state is transmitted from sources 56 to input port 44 through multiplexer 16. The data at input port 44 is manipulated according to the internal logic of programmable logic 12 and transmitted to processed signal receivers 58. A single pulse is applied to clock input 38, causing the output at programmable logic to be read into DCR 14. A logical HIGH is then applied to read input 40 by configuration control 20 and pulses are applied to clock input 38 to produce the current output signature of DCR 14 at signal out port 34. This output signature is then compared to a predetermined correct signature to verify that no error occurred during the first cycle of clock 13.

A logical LOW is again applied to read input 40 by configuration control 20, and system clock 13 executes a second cycle. At the second cycle of system clock 13, the state of sources 56 is again altered and data indicative of the new state is transmitted from sources 56 to input port 44 through multiplexer 16. The data at input port 44 is manipulated according to the internal logic of programmable logic 12 and transmitted to processed signal receivers 58. A pulse is applied to clock input 38, causing the output at programmable logic 12 to be read into, and combined with the previous contents of, DCR 14. Configuration control 20 then applies a logical HIGH to read input 40 and pulses are applied to clock input 38 to produce the current signature of DCR 14 at signal out port 34. This signature is then compared to a second correct signature to verify that no error occurred during the second cycle of clock 13. These steps may be repeated to verify system 15 at each cycle of system clock 13.

If an error is detected during single-step checking, the status of system 15 may be immediately examined. The status of system 15 on the cycle in which the error is identified may provide valuable information to help a user identify the source of the error. For example, when an error is detected in a system having a program counter, the program counter will indicate the instruction whose execution caused the error. By knowing which instruction caused an error, a user can more accurately pinpoint the cause of the error. Further, a user may examine the data at input port 44 on the cycle an error is detected. This information may also be useful in identifying the source of the error.

To perform the single-step checking process described above, clock input 38 must be driven by a timing source that does not affect signal sources 56. Thus, a second clock 57 may be used to drive clock input 38, or circuitry may be provided to isolate system clock 13 from signal sources 56 during the cycles required to generate the output signatures of DCR 14. To drive PRNG 18 during self-testing, clock 57 may also be coupled to PRNG 18 through its clock input 48.

Alternatively, arrangement 10 may perform interval checking, where system 15 is checked every nth cycle of system clock 13. For example, the single stepping process described above may be modified so that the system is checked after every twentieth cycle of clock 13. Thus configured, a logical LOW is applied to read input 40 by configuration control 20 until the twentieth cycle of system clock 13. A single pulse is then applied to the clock input 38 causing the output of PLD 12 to be read into DCR 14. The configuration control 20 then drives read input 40 to a logical HIGH. Subsequent cycles of system clock 13 are applied to clock input 38 to produce an output signature at signal out port 34. When the signature has been produced, configuration control 20 again drives read input 40 to a logical LOW until the fortieth cycle of system clock 13, when the above described process is repeated. Interval checking is advantageous in that it can be performed during real-time operation of programmable logic 12 while being driven by system clock 13. However, interval checking is less thorough than single-step testing in that the outputs generated by programmable logic 12 during the clock cycles used to generate output signatures are not themselves reflected in any output signatures. In addition, the specific instruction whose execution causes an error is not detectable by interval testing, although the range of instructions corresponding to the interval during which the error occurred may be identified.

In an alternate embodiment, multiplexer 16 and PRNG 18 may be removed, and sources 56 may be tied directly to input 44 of programmable logic 12. In this configuration, self-checking can be performed according to the methods described above. However, self-testing is not provided by this alternate embodiment, since programmable logic 12 cannot be independently tested. Thus, errors detected in the output signal of programmable logic 12 may indicate either an error in programmable logic 12 or in signal sources 56.

While the present invention has been described in terms of specific embodiments, it is anticipated that alterations and modifications thereof will no doubt become apparent to those skilled in the art. It is therefore intended that the following claims be interpreted as covering all such alterations and modifications as fall within the true spirit and scope of the invention.

## Claims

1. A programmable logic arrangement disposed in a system having normal signal sources, comprising:
programmable logic having an input and an output, wherein the input of the programmable logic is couplable to the normal signal sources;
a data compression register coupled to the output of the programmable logic, the data compression register having a clock input and a read input, wherein the data compression register compresses data from the output of the programmable logic when the read input is disabled and pulses are applied to the clock input; and
means for disabling the read input of the data compression register when the input of the programmable logic is coupled to the normal signal sources.

2. The arrangement of claim 1 further comprising a pseudo random number generator and a multiplexer having a source selection port, the multiplexer being coupled to the pseudo random number generator, the normal signal sources and the input of the programmable logic, wherein the multiplexer couples the input of the programmable logic array to the pseudo random number generator or the normal signal inputs responsive to a source selection signal applied at the source selection port.

3. The arrangement of claim 2 wherein the source selection port of the multiplexer is controlled independent of the read input of the data compression register.

4. A programmable logic arrangement disposed in a system having normal signal sources and normal processed signal receivers, comprising:
a pseudo random number generator;
programmable logic having an input and an output, wherein the output of the programmable logic is coupled to the normal processed signal receivers;
a multiplexer coupled to the pseudo random number generator, the normal input sources, and the input of the programmable logic, the multiplexer having a source selection input, wherein the multiplexer transmits data from the pseudo random number generator to the programmable logic when the source selection input is enabled, and transmits data from the normal signal sources to the programmable logic when the source selection input is disabled;
a data compression register coupled to the output of the programmable logic, the register having a clock input, a read input, and a signature output, wherein the data compression register receives data from the output of the programmable logic when the read input is disabled and pulses are applied to the clock input, and does not receive input from the output of the programmable logic when the read input is enabled or when pulses are not applied to the clock input; and
means for enabling the source selection input of the multiplexer independently of the read input of the data compression register.

5. The arrangement of claim 4 wherein the data compression register generates an output signature at the signature output when the read input is enabled and pulses are applied to the clock input.

6. A method of testing the integrity of a system including normal signal sources and programmable logic with an input and an output, comprising the steps of:
applying an input signal generated by the normal signal sources to the input of the programmable logic;
generating an output signal at the output of the programmable logic;
compressing the output signal in a data compression register;
generating a signature output representative of the output signal; and
comparing the output signature with a predetermined correct signature.

7. The method of claim 6 wherein the normal signal sources are driven by a system clock, and wherein an output signature is generated and compared to a predetermined correct signature on each cycle of the system clock.

8. The method of claim 7 wherein the signature output is generated by applying a clock signal to the data compression register, and wherein the clock signal is generated by a clock source signal independent of the system clock,

9. A method of testing a system comprising normal input signal sources, a pseudo random number generator, programmable logic having an input and an output, means for selectively coupling the pseudo random number generator and the normal input signal sources to the input of the programmable logic, and a data compression register, comprising the steps of:
coupling the normal input sources to the input of the programmable logic;
applying an input signal generated by normal input sources to the input of the programmable logic;
generating an output signal at the output of the programmable logic;
compressing the output signal in the data compression register;
generating an output signature representative of the output signal; and
comparing the output signature with a predetermined correct signature.

10. The method of claim 9 wherein the input signal is generated during the normal real-time operation of the system.

11. The method of claim 9 wherein the normal input signal sources are driven by a first clock signal source, and the data compression register is driven by a second clock signal source.

12. The method of claim 9 wherein the means for selectively coupling is controlled independently of the data compression register.

13. The method of claim 9 wherein the output signal is compressed in the data compression register for a predetermined interval, and the output signature is representative of the output signal during the predetermined interval.

14. The method of claim 13 wherein the normal input signal sources are driven by a system clock and the predetermined interval is one clock cycle of the system clock.

15. The method of claim 13 wherein the system includes a system clock disposed to drive the normal input signal sources, wherein the step of generating the output signature includes disabling a read input of the data compression register and applying pulses to a clock input of the data compression register, and wherein the pulses applied to the clock input of data compression register are generated by a second clock signal source.
